# DEMANDE DE BREVET EUROPEEN

(11) **EP 2 395 125 A1**
(43) Date de publication de la demande: **14.12.2011**
(21) Numéro de dépôt: 10165287.3
(22) Date de dépôt: 08.06.2010
(51) Int. Cl.: C23C 16/01, A44C 27/00, C22C 16/00

(54) **Procédé de fabrication d'une pièce en métal amorphe revêtue**

(71) Demandeur: The Swatch Group Research and Development Ltd., 2074 Marin (CH)
(72) Inventeur: Winkler, Yves, 3185, Schmitten (CH); Dionne, Jean-François, 3210, Kerzers (CH); Bourban, Stewes, 1588, Cudrefin (CH); Dubach, Alban, 2502, Bienne (CH); Fallet, Yann, 1265, Savagnier (CH)
(74) Mandataire: Giraud, Eric

(57) **Abrégé**

L'invention concerne un procédé de réalisation d'une première pièce (5) ayant au moins une face, formé d'un premier matériau. La première pièce comporte au moins un revêtement (3) sur ladite au moins une face. Le procédé de réalisation comprend les étapes suivantes :
a) se munir d'une seconde pièce (1) comportant une empreinte (2) formant le négatif de la première pièce;
b) déposer ledit revêtement (3), comprenant au moins une première couche, sur ladite seconde pièce ;
c) se munir du premier matériau métallique, ledit premier matériau étant choisi apte à devenir au moins partiellement amorphe;
d) mettre en forme le premier matériau dans ladite empreinte de la seconde pièce de façon à permettre la solidarisation dudit revêtement à ladite au moins une face de ladite première pièce, ledit premier matériau ayant subit au plus tard au moment de ladite mise en forme un traitement lui permettant de devenir au moins partiellement amorphe;
e) séparer la première pièce de la seconde pièce de sorte à obtenir ladite première pièce revêtue dudit revêtement.

## Description

La présente invention concerne un procédé de réalisation d'une première pièce ayant au moins une face, formé d'un premier matériau. La première pièce comporte au moins un revêtement sur ladite au moins une face.

Le domaine technique de l'invention est le domaine technique de la mécanique fine. Plus précisément, l'invention appartiendra au domaine technique des méthodes de fabrication des pièces en métal amorphe revêtue.

### ARRIERE PLAN TECHNOLOGIQUE

Il est connu de déposer un revêtement sur diverses pièces et matériaux pour diverses applications esthétiques ou fonctionnelles. Les méthodes connues pour de tels dépôts sont typiquement les techniques de dépôt chimique en phase vapeur (CVD), de dépôt physique en phase vapeur (PVD) ou d'électro-déposition par exemple.

Néanmoins, ces procédés ont l'inconvénient de créer des inhomogénéités d'épaisseurs dans le cas de certaines géométries complexes comme par exemple les géométries concaves. Cela peut, par exemple, se traduire par un lissage de surface dans le cas d'une surface dite « clous de Paris » dans le domaine technique de l'horlogerie.

De plus, ces procédés ont l'inconvénient de ne pas permettre une grande flexibilité pour le choix des couples de matériaux substrat-couche. En effet, en pratique, il n'est pas possible de déposer n'importe quelle couche sur n'importe quel matériau et avec des épaisseurs importantes. Ceci est dû à différents facteurs comme les contraintes thermiques ou la structure cristallographique incompatible entre le matériau du substrat et celui de la couche ou autres.

Il est également connu un procédé pour déposer un revêtement en diamant qui permet de s'affranchir, en partie, de ces inconvénients. Ce procédé, connu du document FR 2 815 045, comprend les étapes suivantes :
1) Réaliser le négatif de la pièce, que l'on veut fabriquer, en silicium ;
2) Déposer une couche en diamant de 2µm sur le négatif par dépôt chimique en phase vapeur (CVD) ;
3) Surmouler le négatif à l'aide d'une résine époxy ;
4) Dissoudre sélectivement le négatif avec de l'acide fluorhydrique sans dissoudre la résine époxyde ni la couche diamant.

Or, ce procédé a l'inconvénient de n'être utilisable que pour des plastiques ou polymères et non pour des métaux cristallins. En effet, l'utilisation du métal cristallin pour un tel procédé de dépôt d'un revêtement n'est pas possible pour plusieurs raisons.

En premier lieu, les métaux n'ont, en général, pas de propriétés d'adhérence comme peut l'avoir une résine ou une matière plastique. En effet, l'époxy est un polymère qui, lorsqu'il polymérise, présente les propriétés d'une colle ayant un bon facteur de traction avec des matériaux comme le bois, le métal, le verre, etc. Dès lors, comme les métaux ont de faibles propriétés d'adhésion, l'application du procédé décrit dans le brevet FR 2 815 045 à un métal cristallin ne va pas permettre le dépôt d'une couche qui va adhérer sur la pièce à réaliser.

En second lieu, certaines caractéristiques des métaux peuvent empêcher leur utilisation dans le cadre du procédé décrit dans l'art antérieur. Ainsi, en général, pour que les métaux puissent être mis en forme dans un moule, il est nécessaire de les mettre sous forme liquide, c'est-à-dire de les faire fondre. Or, un certain nombre de métaux ont une température de fusion dépassant les 1000 °C. Par conséquent, une telle température de fusion peut endommager la couche déposée sur le négatif, particulièrement si ladite couche est peu épaisse, voire endommager le négatif lui-même.

Comme autres caractéristiques pouvant pousser l'homme du métier à ne pas utiliser les métaux dans le cadre du procédé décrit dans l'art antérieur, on peut citer le retrait de solidification ou la différence entre les coefficients de dilatation de la couche et du métal. En effet, le retrait de solidification consiste en une contraction du métal sur lui-même lors de la solidification. Cela induit alors une réduction des dimensions de la pièce solide par rapport aux dimensions du négatif de l'ordre de 5 à 7%. Il y a donc un risque de délamination entre la couche et le métal solidifié. Un tel risque de délamination peut être également engendré par la différence entre les coefficients de dilatation de la couche et du métal, le coefficient de dilatation du métal étant généralement plus grand que celui de la couche.

Dès lors, il est raisonnable de penser que l'homme du métier n'aurait pas utilisé le procédé décrit dans le brevet FR 2 815 045 pour fabriquer une pièce en métal revêtue d'une couche.

### RESUME DE L'INVENTION

L'invention concerne un procédé de réalisation d'une première pièce qui pallie les inconvénients de l'art antérieur en permettant la fabrication d'une première pièce en un matériau donné, dit ci-après « un premier matériau », revêtue d'un revêtement ayant une bonne accroche de ladite couche sur le métal et une bonne flexibilité dans le choix du métal qui sera revêtu et du revêtement qui sera déposé. Ledit premier matériau peut être un alliage, métal ou matériau comportant au moins un élément métallique.

A cet effet, l'invention concerne le procédé de réalisation d'une première pièce citée ci-dessus qui se caractérise en ce qu'il comprend les étapes suivantes :
a) se munir d'une seconde pièce comportant une empreinte formant le négatif de la première pièce;
b) déposer ledit revêtement, comprenant au moins une première couche, sur ladite seconde pièce ;
c) se munir du premier matériau métallique, ledit premier matériau étant choisi apte à devenir au moins partiellement amorphe;
d) mettre en forme le premier matériau dans ladite empreinte de la seconde pièce de façon à permettre la solidarisation dudit revêtement à ladite au moins une face de ladite première pièce, ledit premier matériau ayant subit au plus tard au moment de ladite mise en forme un traitement lui permettant de devenir au moins partiellement amorphe;
e) séparer la première pièce de la seconde pièce de sorte à obtenir ladite première pièce revêtue dudit revêtement.

Un avantage de la présente invention est de permettre une grande facilité dans la mise en forme en particulier dans le cas d'un premier matériau au moins partiellement amorphe permettant l'élaboration de pièces aux formes compliquées avec une plus grande précision. En effet, les métaux amorphes ont la caractéristique particulière de se ramollir tout en restant amorphe durant un certain temps dans un intervalle de température [Tg - Tx] donné propre à chaque alliage (avec Tx : température de cristallisation et Tg : température de transition vitreuse) (par exemple pour un alliage Zr_{41.24}Ti_{13.75}Cu_{12.5}Ni₁₀Be_{22.5}: Tg = 350°C, Tx = 460°C). Il est ainsi possible de les mettre en forme sous une contrainte relativement faible et à une température peu élevée permettant alors l'utilisation d'un procédé simplifié. L'utilisation d'un tel matériau permet en outre de reproduire très précisément des géométries fines car la viscosité de l'alliage diminue fortement en fonction de la température dans l'intervalle de température [Tg - Tx] et l'alliage épouse ainsi tous les détails du négatif. Par exemple, pour un matériau à base de platine, la mise en forme se fait aux alentours de 300°C pour une viscosité atteignant 10³ Pa.s pour une contrainte de 1 MPa, au lieu d'une viscosité de 10¹² Pa.s à la température Tg.

Cette capacité de se ramollir, dans un intervalle de température [Tg - Tx] relativement faible, permet au métal amorphe d'avoir, de façon surprenante, une capacité d'adhérence que ne possède pas un métal cristallin.

Un autre avantage de la présente invention est de permettre le dépôt d'un revêtement sur du métal amorphe sans risquer une cristallisation de ce dernier ce qui détruirait certaines de ses propriétés comme la mise en forme ou sa capacité à ne pas avoir de retrait de solidification. En effet, il est possible que le dépôt d'un revêtement sur un substrat nécessite une température du procédé supérieure à la température de cristallisation du substrat. Si celui-ci est un métal amorphe, il y a donc un risque de cristallisation. Avec la présente invention, ce risque n'existe pas puisque le revêtement est d'abord déposé sur le négatif dont le matériau est choisi pour être parfaitement compatible avec le revêtement. Dès lors, la température de fonctionnement du procédé de dépôt du revêtement sur la seconde pièce n'est pas appliquée sur le métal amorphe écartant tout risque de cristallisation.

Des modes de réalisation avantageux de ce procédé de dépôt d'un revêtement font l'objet des revendications dépendantes 2 à 19.

Un des avantages de ces modes de réalisation est le bon accrochage. En effet, l'accrochage peut être amélioré en structurant le revêtement de sorte que ce dernier comprenne des reliefs. Ces reliefs pouvant se présenter sous forme de creusures ou de saillies permettent au métal amorphe de s'incruster et donc d'opérer une accroche, améliorant ainsi l'adhérence.

### BREVE DESCRIPTION DES FIGURES

Les buts, avantages et caractéristiques du procédé de réalisation d'une première pièce selon la présente invention apparaîtront plus clairement dans la description détaillée suivante d'au moins une forme de réalisation de l'invention donnée uniquement à titre d'exemple non limitatif et illustrée par les dessins annexés sur lesquels :
- les figures 1 à 7 représentent de manière schématique les étapes du procédé selon la présente invention;
- la figure 8 représente de manière schématique un revêtement ayant plusieurs couches;
- la figure 9 représente de manière schématique un revêtement selon une première variante de la présente invention;
- la figure 10 représente de manière schématique un revêtement selon une seconde variante de la présente invention ;
- les figures 11 à 16 représentent de manière schématique une première alternative d'une quatrième variante du procédé selon la présente invention et
- les figures 17 à 22 représentent de manière schématique une seconde alternative d'une quatrième variante du procédé selon la présente invention.

### DESCRIPTION DETAILLEE

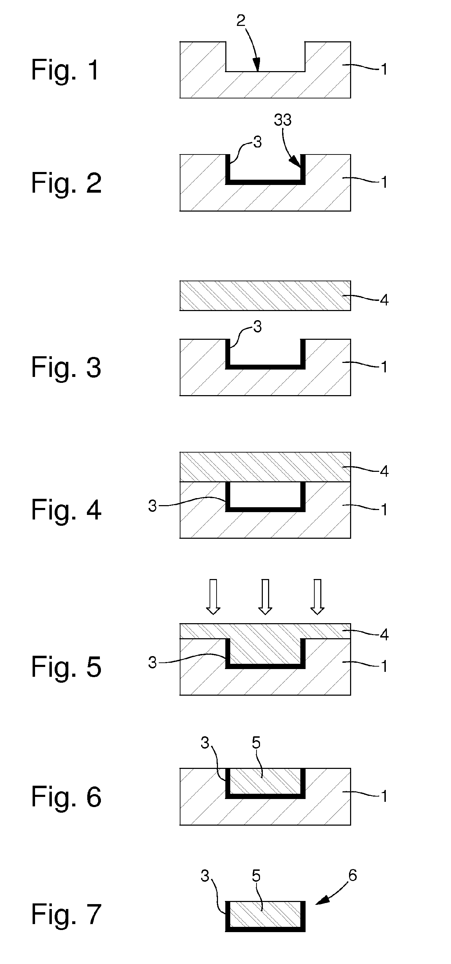

Les figures 1 à 7 représentent les différentes étapes du procédé de réalisation d'une première pièce selon la présente invention. Ce procédé permet de réaliser une première pièce 5 pourvue d'un habillage se présentant sous la forme d'un revêtement 3. Ce revêtement 3 est du type superficiel c'est à dire qu'il est directement appliqué sur la première pièce 5 sur au moins une de ses surfaces de contact. Cette première pièce 5 est réalisée en un premier matériau. Cette première pièce 5 peut être une pièce esthétique ou fonctionnelle, comme une boîte de montre, un rouage, une lunette de montre, une pièce indépendante ou un élément d'un système comme une montre. Cette première pièce 5 peut également faire office de moule dans lequel des éléments seront fabriqués. En effet, s'il est intéressant d'avoir des pièces esthétiques ou fonctionnelles revêtues, il peut également être intéressant d'avoir un moule possédant un revêtement 3 spécifique, comme un revêtement diamant permettant une bonne résistance aux matériaux abrasifs.

La première étape, représentée à la figure 1, consiste à se munir du négatif 1 de la première pièce 5 que l'on désire fabriquer et revêtir. Pour cela, une opération classique de fabrication d'un moule est réalisée. Ce négatif 1, appelé aussi seconde pièce, est constitué d'un matériau appelé second matériau. Ce négatif 1 comprend une empreinte 2 qui est l'empreinte de la pièce à réaliser.

La seconde étape, représentée à la figure 2, consiste à déposer, sur le négatif 1, le revêtement 3 que l'on désire appliquer sur la première pièce 5. Pour cela, il est prévu de se munir du matériau constitutif du revêtement 3. Ce matériau, appelé troisième matériau, conditionne le choix du second matériau constitutif du négatif 1. En effet, le revêtement 3 est d'abord déposé sur le négatif 1 avant d'être transféré sur la première pièce 5. Dès lors, il y a un avantage à ce que le matériau du négatif 1 soit choisi pour optimiser le dépôt dudit revêtement 3 permettant d'éliminer les incompatibilités entre la pièce à revêtir et le matériau constituant le revêtement 3. Par exemple, pour le dépôt d'une couche diamant, on utilisera un négatif en silicium.

Le dépôt en lui-même consiste en l'utilisation d'un procédé de dépôt connu comme la technique de dépôt chimique en phase vapeur (CVD), de dépôt physique en phase vapeur (PVD) ou d'électro-déposition ou autres. On comprendra que la technique utilisée peut être dépendante du matériau à déposer de sorte que le dépôt soit optimal.

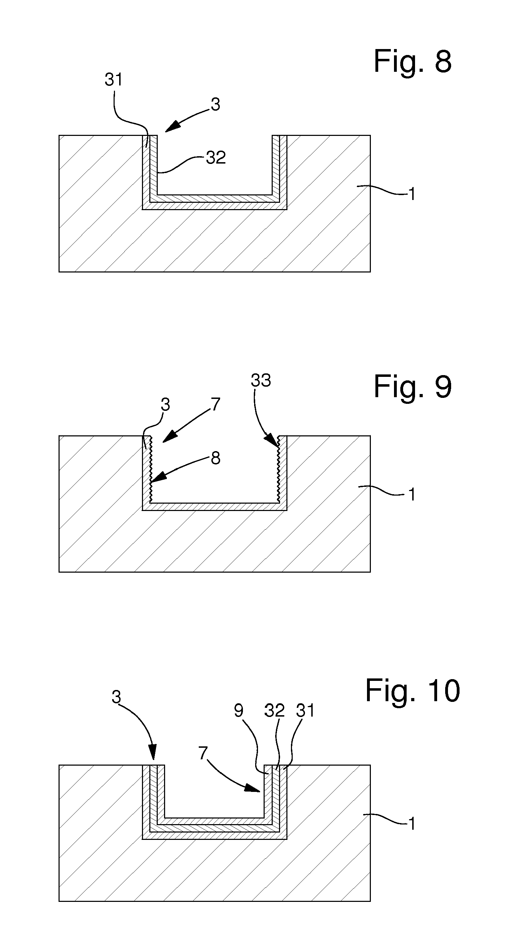

Il est également possible que le revêtement comprenne plusieurs couches de matériaux différents comme visible à la figure 8. Le revêtement 3 comprend alors au moins deux couches, une première couche 31 déposée correspondant à la couche qui sera confrontée aux éléments extérieurs et une seconde couche 32, qui est la dernière couche déposée et qui interagira avec le premier matériau de la première pièce 5. Ainsi, cette superposition de différentes couches peut entraîner des avantages esthétiques et mécaniques comme par exemple une résistance à la fatigue améliorée ou un meilleur comportement tribologique ou une tenue aux chocs supérieure. Par exemple, on peut avoir une couche or sur une couche DLC afin de combiner l'aspect précieux de l'or avec les caractéristiques de dureté de la couche DLC.

Les revêtements 3 typiques utilisables sont par exemple: le diamant, le DLC (Diamond Like Carbon), le nitrure de titane (TiN), le nitrure de zirconium (ZrN), le carbure de titane (TiC), le carbure de zirconium (ZrC), le nitrure de silicum (Si₃N₄), le dioxyde de silicium (SiO₂), le carbure de silicium (SiC), le nitrure de bore (BN), l'or (Au), l'argent (Ag), le nickel (Ni), le chrome (Cr), le palladium (Pd), le platine (Pt), le silicium (Si), le rhodium (Rh) ou autres (Les épaisseurs peuvent être de 0.1µm à 20µm pour des dépôts céramique et jusqu'à plusieurs centaines de microns pour des dépôts métalliques).

On comprendra que le dépôt du revêtement 3 ne soit pas réalisé sur la totalité de la surface du négatif 1 et peut être uniquement réalisé sur la surface de l'empreinte 2 devant être revêtue. Il est également possible qu'une partie seulement de l'empreinte 2 soit soumise au dépôt du revêtement 3. De plus, on peut également imaginer que l'habillage comprenne plusieurs revêtements, chaque revêtement étant agencé sur une surface du négatif 1 correspondant à une surface de la première pièce 5. Ainsi, on peut imaginer que le fond du négatif 1 comprenne un revêtement diamant et que les flancs comprennent un revêtement en or. Néanmoins, il est également possible que toute la surface du négatif 1 soit revêtue et que le surplus de revêtement 3 soit éliminé par action mécanique ou chimique.

La troisième étape, représentée à la figure 3, consiste à se munir du premier matériau, c'est-à-dire du matériau constitutif de la première pièce 5. Afin de réaliser une pièce en métal revêtue avec une bonne accroche du revêtement et une bonne flexibilité dans le choix du métal et du revêtement 3, il est prévu que le premier matériau soit un matériau au moins partiellement amorphe. Plus particulièrement, le matériau est métallique, on comprend par là qu'il comporte au moins un élément métallique. Le premier matériau peut être un alliage métallique homogène ou un métal au moins partiellement ou totalement amorphe. Le premier matériau est ainsi choisi apte à perdre localement toute structure cristalline lors d'une montée en température au dessus de sa température de fusion suivie d'un refroidissement à une température inférieure à sa température de transition vitreuse lui permettant de devenir au moins partiellement amorphe.

La quatrième étape, représentée aux figures 4 à 6, consiste à mettre en forme le premier matériau, ici du métal amorphe, de sorte à réaliser la première pièce. Pour cela, le procédé de formage à chaud est utilisé.

En tout premier lieu, une préforme 4 en matériau amorphe est réalisée. Cette préforme 4 consiste en une pièce d'aspect et de dimensions similaires à la pièce finale. Typiquement, si l'on veut réaliser, par exemple, une membrane circulaire, la préforme 4 se présentera sous la forme d'un disque. Un point important est que ladite préforme 4 ait déjà une structure amorphe. Pour cela, le ou les matériaux constituant le premier matériau sont mis sous forme liquide par élévation de la température au dessus de leur température de fusion. Ils sont ensuite mélangés de façon homogène, si le premier matériau comprend plusieurs éléments, de sorte à former ledit premier matériau. Ce mélange est ensuite coulé dans un moule de forme désirée puis le tout est refroidi aussi vite que possible de sorte que les atomes n'aient pas le temps de se structurer. Le premier matériau devient alors au moins partiellement amorphe.

La préforme 4 est ensuite disposée sur le négatif 1 de sorte à le recouvrir comme représenté sur la figure 4. La presse à chaud est alors mise en température jusqu'à atteindre une température spécifique au matériau, préférentiellement, entre sa température de transition vitreuse Tg et sa température de cristallisation Tx.

Une fois la presse à chaud en température, une pression est alors exercée sur la préforme 4 afin de remplir le négatif 1 comme représenté à la figure 5. Cette opération de pressage est effectuée pendant un laps de temps prédéfini.

Cette opération est possible car l'avantage des métaux amorphes est qu'ils ont la caractéristique particulière de se ramollir tout en restant amorphes dans un intervalle de température [Tg - Tx] donné propre à chaque alliage et peu élevé car ces températures Tg et Tx sont peu élevées. Cela permet alors de reproduire très précisément des géométries fines et précises car la viscosité de l'alliage diminue fortement et ce dernier peut être facilement déformé afin d'épouser tous les détails de l'empreinte 2 du négatif 1. De plus, la faible température nécessaire à la mise en forme des métaux amorphes permet de ne pas dégrader le négatif 1 ou le revêtement 3.

Une fois le temps de pressage écoulé, il est prévu de refroidir le premier matériau en-dessous de Tg afin de former la première pièce 5. Le pressage et le refroidissement doivent être suffisamment rapides pour éviter la cristallisation du premier matériau. En effet, pour un premier matériau donné et à une température donnée entre sa température de transition vitreuse Tg et sa température de cristallisation Tx, il existe une durée limite au-delà de laquelle, ledit matériau cristallise. Cette durée diminue lorsque la température approche sa température de cristallisation Tx et cette durée augmente lorsque la température approche sa température de transition vitreuse Tg. Ainsi, le matériau amorphe va cristalliser si le temps passé à une température comprise entre Tg et Tx excède une certaine valeur spécifique pour chaque couple température/alliage. Typiquement pour l'alliage Zr41.2Ti13.8Cu12.5Ni10Be22.5 et pour une température de 440°C, le temps de pressage ne devra pas dépasser 120 secondes environ. Ainsi, le formage à chaud permet de conserver l'état au moins partiellement amorphe initial de la préforme 4.

Comme variante à cette quatrième étape, il peut être envisagé d'utiliser un procédé de coulée pour réaliser la première pièce 5. Ce procédé consiste à prendre le premier matériau dont on s'est muni lors de la troisième étape sans pour autant lui avoir fait subir un traitement le rendant au moins partiellement amorphe et de le mettre sous forme liquide. Cette mise sous forme liquide se fait par fusion dudit premier matériau.

Une fois le premier matériau sous forme liquide, celui-ci est coulé dans l'empreinte 2 du négatif 1. Lorsque l'empreinte 2 du négatif 1 est remplie ou au moins partiellement remplie, le premier matériau est alors refroidi de sorte à lui donner une forme amorphe. Pour cela, le premier matériau est refroidi rapidement afin que les atomes le constituant ne s'arrangent pas sous forme cristalline.

Un avantage de la coulée d'un métal ou alliage capable d'être amorphe, est d'avoir une température de fusion peu élevée. En effet, les températures de fusion des métaux ou alliages capables d'avoir une forme amorphe, sont en général deux à trois fois plus faibles que celles des alliages classiques lorsque l'on considère des compositions de mêmes types. Par exemple, la température de fusion de l'alliage Zr41.2Ti13.8Cu12.5Ni10Be22.5 est de 750°C comparé au 1500-1700°C des alliages cristallins à base de zirconium Zr et titane Ti. Cela permet ainsi de ne pas risquer d'endommager le revêtement 3 lors de la coulée.

Un autre avantage est que le retrait de solidification, pour un métal amorphe, est très faible, moins de 1% par rapport au retrait de 5 à 7% pour un métal cristallin. Cet avantage permet alors d'utiliser le principe de la coulée sans craindre de déchaussement ou de délaminage qui serait la conséquence dudit retrait.

Il est prévu d'enlever le surplus de matière mécanique ou chimique comme représenté à la figure 6. Ce surplus peut être enlevé avant ou après le refroidissement.

La cinquième étape, représentée à la figure 7, consiste à séparer la première pièce revêtue 6 du négatif 1. Pour cela, le négatif 1, dans lequel le métal amorphe a été surmoulé pour former la première pièce 5, est enlevé mécaniquement ou plongé dans une solution chimique. Cette solution chimique est choisie pour attaquer spécifiquement le négatif 1. En effet, le but de cette étape est de dissoudre le négatif 1 sans dissoudre ni le revêtement 3 ni la première pièce 5 constituée de métal amorphe. Par exemple, dans le cas d'un négatif 1 réalisé en silicium, une solution d'hydroxyde de potassium ou potasse (KOH) est utilisée pour dissoudre le silicium du négatif 1. Le résultat final est alors l'obtention de la première pièce en métal amorphe revêtue 6.

Dans une première variante de la présente invention visible à la figure 9, il est prévu d'améliorer l'accroche entre le revêtement 3 et le métal amorphe constituant la première pièce 5. Pour cela, le revêtement 3 comprend des moyens d'accrochage 7. Ces moyens d'accrochage 7 se présentent sous la forme de rugosités, porosités ou reliefs 8. Ces reliefs 8 sont réalisés sur la couche qui sera en contact avec le métal amorphe lorsque celui-ci sera surmoulé dans le négatif 1. Dans le cas où le revêtement 3 ne comprend qu'une seule couche, les reliefs 8 seront réalisés sur cette unique couche. Par contre, si le revêtement 3 comprend plusieurs couches 31, 32 comme visible à la figure 8, les reliefs 8 seront préférentiellement réalisés sur la dernière couche du revêtement 3 qui sera déposée, c'est-à-dire la couche 32 de la figure 8. Il en sera de même si le revêtement 3 comprend trois ou quatre couches.

Ces reliefs 8 se présentent sous la forme de saillies ou de creusures. Ces reliefs 8 permettent alors d'utiliser les propriétés de mise en forme des matériaux amorphes. En effet, comme dit plus haut, les matériaux amorphes ont l'avantage de reproduire très précisément des géométries fines et précises car la viscosité du métal amorphe diminue fortement et ce dernier épouse ainsi tous les détails du négatif 1, y compris les reliefs 8. Ces derniers permettent alors un ancrage du métal amorphe audit revêtement 3 et donc une résistance à l'arrachement et un accrochage supérieur du revêtement 3 à la première pièce 5.

Ces reliefs 8 sont réalisés, par exemple, lors du dépôt du revêtement 3 par variations des paramètres de déposition. On peut également prévoir que ces reliefs 8 sont réalisés, par exemple, par photolithographie, par gravage laser ou plasma ou par microsablage. Ces reliefs 8 sont préférentiellement réalisés sur les flancs 33 dudit revêtement 3 réalisé sur le négatif 1 de sorte à opérer une retenue verticale empêchant ainsi le revêtement 3 de se désolidariser de la première pièce 5 en métal amorphe.

Dans une seconde variante, il est prévu que l'accrochage soit amélioré par utilisation d'une couche intermédiaire 9. En effet, dans cette variante, la dernière couche déposée lors de la deuxième étape est une couche favorisant l'ancrage dudit revêtement 3 à la première pièce 5, c'est-à-dire, favorisant l'ancrage dudit revêtement 3 au métal amorphe. Cette couche intermédiaire 9 peut être spécialement déposée en plus des couches constituant le revêtement 3 pour opérer ledit ancrage c'est-à-dire qu'elle se situe entre la couche du revêtement 3 la plus proche de la première pièce 5 et la première pièce 5. Néanmoins, il est possible d'utiliser une couche déjà existante, de préférence la dernière couche déposée, pour favoriser l'ancrage dudit revêtement 3. C'est-à-dire que sur la figure 8 où le revêtement 3 comprend deux couches 31, 32, la couche intermédiaire serait la couche 32. De plus, il est bien entendu possible d'associer des reliefs 8 avec une couche intermédiaire 9. L'ancrage peut se faire par utilisation de deux principes différents.

Premièrement, la couche intermédiaire 9 est choisie pour posséder une forte affinité chimique avec, à la fois, la couche du revêtement 3 sur laquelle cette couche intermédiaire 9 est déposée et le premier matériau constitutif la première pièce 5. Cette forte affinité chimique se caractérise par un processus d'inter-diffusion accéléré entre les atomes de la couche intermédiaire 9 et les atomes de la couche du revêtement 3 sur laquelle la couche intermédiaire 9 est déposée et du métal amorphe. Ce processus consiste à une diffusion réciproque d'atomes afin de lier les différents matériaux les uns aux autres. La profondeur de la diffusion est liée au coefficient de diffusion d'un atome dans un réseau d'autres atomes, à la température qui varie exponentiellement et au temps qui varie selon une racine carrée. En général, des profondeurs de diffusions de 1-100µm sont des valeurs possibles. Toutefois si l'épaisseur de la couche est égale ou inférieure à 1 µm, les profondeurs de diffusions seront plutôt de l'ordre de 10 à 100nm.

Deuxièmement, l'accrochage peut être opéré par brasage. En effet, cette solution consiste à utiliser la couche intermédiaire 9 comme élément d'apport pour une brasure. Pour cela, on utilise un matériau ayant une température de fusion peu élevée comme par exemple l'étain ayant une température de fusion de 231 °C. Cette faible température de fusion permet à ladite couche intermédiaire 9 de passer d'une forme solide à une forme liquide lors de l'opération de formage à chaud du métal amorphe. Cela entraîne alors un brasage entre le revêtement 3 et le matériau amorphe de la première pièce 5 permettant une bonne accroche dudit revêtement 3. Bien entendu, le matériau constitutif de la couche intermédiaire 9 sera choisi pour ne pas endommager le revêtement 3 lors de la fusion de ladite couche intermédiaire 9. Cette couche intermédiaire 9 peut atteindre des épaisseurs de 1 à 10µm.

Par ailleurs, il peut être prévu que le brasage par l'intermédiaire de la couche intermédiaire 9 soit réalisé après le refroidissement de la première pièce mais avant la séparation de ladite première pièce 5 et du négatif 3. Ce brasage est réalisé par une montée en température de ladite première pièce 5 pour mettre en fusion la couche intermédiaire 9 et ainsi braser le revêtement 3 et la première pièce 5. Le matériau constitutif de la couche intermédiaire 9 est choisi pour ne pas dépasser la température de fusion du matériau constitutif de la première pièce 5 et du matériau constitutif du revêtement 3.

On comprend que ces deux premières variantes de l'invention permettent d'obtenir une pièce terminée possédant les qualités d'un matériau amorphe. La chute de la viscosité du métal amorphe dans le domaine [Tg - Tx] permet aussi de réaliser des pièces pour lesquelles les qualités intrinsèques du métal amorphe ne sont pas nécessaires, mais qui ne pourraient pas être obtenues autrement, et où les propriétés du métal amorphe sont utilisées seulement lors de leur élaboration.

Dans une troisième variante non représentée sur les figures, il peut être envisagé d'améliorer l'accroche du revêtement 3 à la première pièce 5 en métal amorphe par cristallisation. Cette méthode est utilisable dans le cas où la caractéristique amorphe du métal constituant la première pièce 5 n'est pas nécessaire. Le caractère amorphe dudit métal ne sert alors que pour la mise en forme.

La cristallisation consiste en une sixième étape réalisée soit après la cinquième étape soit durant la quatrième étape. Cette étape se fait par traitement thermique de la première pièce revêtue 6 à une température supérieure à la température de transition vitreuse du métal amorphe. Selon la température et le temps choisis, l'alliage cristallisera et pourra présenter diverses microstructures comme par exemple une structure nanocristalline. Bien entendu, la température est ajustée de sorte à ne pas abîmer le revêtement 3. Le fait de cristalliser le métal amorphe permet d'augmenter le processus d'inter-diffusion entre les atomes de la couche d'adhésion et les atomes du métal, ceci soit par le temps soit par la température. Il en résulte que les atomes de la couche intermédiaire 9 et les atomes du métal diffusent l'un dans l'autre améliorant ainsi l'accroche entre ledit revêtement 3 et la première pièce 5.

Préférentiellement, le premier matériau constituant la première pièce 5 et les conditions de cristallisation sont définis de sorte à permettre la formation de dendrites plutôt que des phases intermétalliques. Ces dendrites permettent d'éviter une trop grande fragilité du métal cristallisé.

Dans une quatrième variante, le négatif 1 dans lequel la première pièce 5 est réalisée comprend deux matrices. En effet, il est possible que la première pièce 5 à réaliser soit de géométrie complexe ne permettant pas de déposer ledit revêtement 3 dans de bonnes conditions.

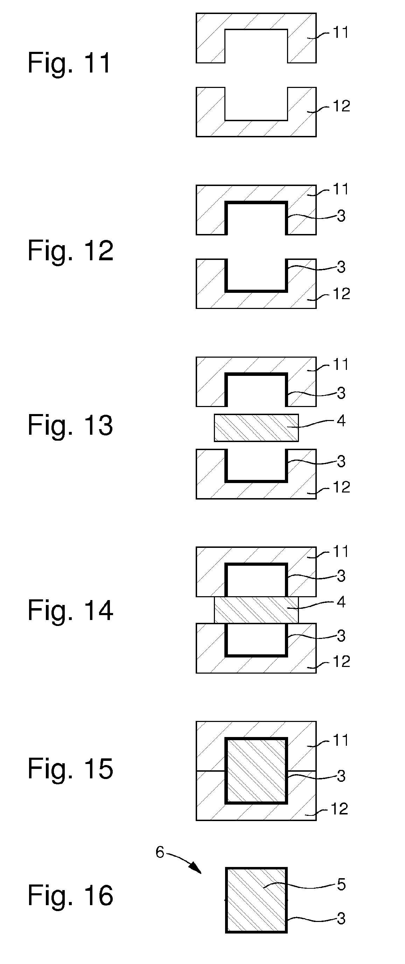

Dans une première alternative représentée aux figures 11 à 16, les deux matrices 11 et 12 du négatif 1 sont utilisées pour réaliser un revêtement 3 intégral. En effet, le procédé décrit aux figures 1 à 7 ne permet pas la réalisation de première pièce 5 entièrement revêtue. Cela est dû principalement au fait qu'une seule matrice 1 est utilisée. La solution est donc d'utiliser deux matrices 11, 12 qui sont toutes les deux revêtues du revêtement 3 comme visible à la figure 12. La première pièce 5 est ensuite réalisée selon le procédé de formage à chaud précédemment décrit et visible aux figures 13 à 15. On obtient alors une première pièce revêtue 6 comme visible à la figure 16, cette pièce 6 étant alors intégralement revêtue.

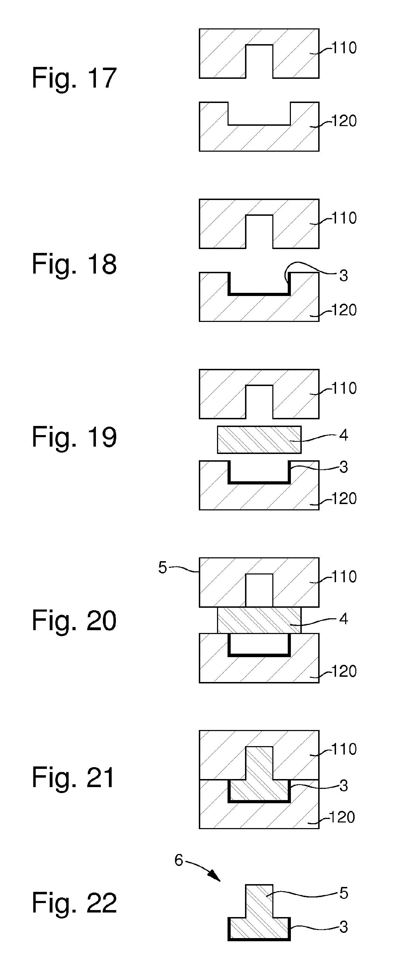

Dans une seconde alternative représentée aux figures 17 à 22, une seule des matrices 110, 120 comprend le revêtement 3. L'intérêt de cette alternative est de permettre la réalisation de pièce complexe partiellement revêtue. Par exemple, soit le cas où l'on veut réaliser une vis en métal amorphe ayant une tête de vis avec un revêtement 3 diamant et un corps non revêtu. Cette pièce est complexe car la tête de vis est plus large que le corps. Ainsi, la fabrication de cette vis avec une seule matrice est très complexe et le dépôt du revêtement 3 seulement au niveau de la tête de vis est également difficile. Une solution est celle qui est représentée à la figure 18. C'est-à-dire qu'une matrice 120 a une empreinte 2 similaire à celle de la tête de vis et sera revêtue du revêtement 3 diamant alors que la seconde matrice 110 a une empreinte 2 dont la forme est similaire à celle du corps de la vis et ne sera pas revêtue. Cela permet, lors du formage à chaud représenté au figures 18 à 20, de réaliser la vis désirée, c'est-à-dire partiellement revêtue.

On comprendra que diverses modifications et/ou améliorations et/ou combinaisons évidentes pour l'homme du métier peuvent être apportées aux différents modes de réalisation de l'invention exposés ci-dessus sans sortir du cadre de l'invention défini par les revendications annexées.

Ainsi, on peut comprendre que le premier matériau constituant la première pièce 5 est un matériau amorphe précieux.

On peut également comprendre que la première étape consistant à se munir du négatif 1 peut comprendre aussi le fait de préparer ledit négatif 1. En effet, il est possible de décorer le négatif 1 de sorte que des états de surface puissent être directement réalisés sur la première pièce revêtue 6. Ces états de surface peuvent être une décoration « côte de Genève », perlée, colimaçonnée diamant ou un satinage.

La mise en oeuvre d'une des variantes du procédé selon l'invention, permet encore d'appliquer, à des surfaces différentes de la première pièce 5, des revêtements différents.

Elle permet aussi de superposer les revêtements, au niveau de certaines surfaces. Il est par exemple aussi possible de réaliser des surfaces colorées protégées par une couche vitrifiée, permettant toutes les audaces en joaillerie. Il est encore possible, lors de la mise en oeuvre du revêtement 3, de créer des décors en deux et/ou en trois dimensions, tels que logos, images ou autres.

## Revendications

1. Procédé de réalisation d'une première pièce (5) ayant au moins une face, formé d'un premier matériau et comportant au moins un revêtement (3) sur ladite au moins une face, **caractérisé en ce qu'**il comprend les étapes suivantes :
a) se munir d'une seconde pièce (1) comportant une empreinte (2) formant le négatif de la première pièce;
b) déposer ledit revêtement (3), comprenant au moins une première couche, sur ladite seconde pièce;
c) se munir du premier matériau métallique, ledit premier matériau étant choisi apte à devenir au moins partiellement amorphe;
d) mettre en forme le premier matériau dans ladite empreinte de la seconde pièce de façon à permettre la solidarisation dudit revêtement à ladite au moins une face de ladite première pièce (5), ledit premier matériau ayant subit au plus tard au moment de ladite mise en forme un traitement lui permettant de devenir au moins partiellement amorphe;
e) séparer la première pièce (5) de la seconde pièce de sorte à obtenir ladite première pièce revêtue dudit revêtement (3).

2. Procédé de réalisation selon la revendication 1, **caractérisé en ce que** l'étape e) consiste à dissoudre ladite seconde pièce (1).

3. Procédé de réalisation selon les revendications 1 ou 2, **caractérisé en ce que** ledit premier matériau est soumis à une montée en température au dessus de sa température de fusion lui permettant de perdre localement toute structure cristalline, ladite montée étant suivie d'un refroidissement à une température inférieure à sa température de transition vitreuse permettant audit premier matériau de devenir au moins partiellement amorphe.

4. Procédé de réalisation selon l'une des revendications 1 à 3, **caractérisé en ce que** l'étape d) consiste à mettre en forme ledit premier matériau seulement après l'avoir au préalable transformé en une préforme (4) au moins partiellement amorphe, ladite préforme étant ensuite soumise à une température comprise entre la température de transition vitreuse et la température de cristallisation du premier matériau puis à une opération de formage par pression suivie d'une opération de refroidissement permettant audit premier matériau de garder une nature au moins partiellement amorphe.

5. Procédé de réalisation selon l'une des revendications 1 à 3, **caractérisé en ce que** l'étape d) de mise en forme est simultanée avec un traitement rendant ledit premier matériau au moins partiellement amorphe, en le soumettant à une température supérieure à sa température de fusion suivie d'un refroidissement à une température inférieure à sa température de transition vitreuse lui permettant de devenir au moins partiellement amorphe, lors d'une opération de coulée.

6. Procédé de réalisation selon l'une des revendications précédentes, **caractérisé en ce que** des moyens d'accrochage (7) sont agencés sur ledit revêtement (3) afin d'améliorer l'accrochage entre ledit revêtement (3) et la première pièce (5).

7. Procédé de réalisation selon l'une des revendications 1 à 5, **caractérisé en ce que** des moyens d'accrochage (7) sont agencés sur une couche constitutive dudit revêtement (3) afin d'améliorer l'accrochage entre ladite couche d'une part et d'autre part ladite première pièce ou une autre couche dudit revêtement.

8. Procédé de réalisation selon les revendications 6 ou 7, **caractérisé en ce que** les moyens d'accrochage (7) comprennent au moins un relief (8) en creux ou en saillie agencé sur le revêtement (3).

9. Procédé de réalisation selon la revendication 8, **caractérisé en ce que** ledit au moins un relief (8) est réalisé par variation du procédé de dépôt dudit revêtement (3).

10. Procédé de réalisation selon la revendication 8, **caractérisé en ce que** ledit au moins un relief est réalisé par usinage dudit revêtement (3).

11. Procédé de réalisation selon l'une des revendications 6 à 10, **caractérisé en ce que** les moyens d'accrochage (7) comprennent une couche intermédiaire (9) agencée entre la couche du revêtement la plus proche de la première pièce et la première pièce (5).

12. Procédé de réalisation selon l'une des revendications 6 à 10, **caractérisé en ce que** ledit revêtement (3) comprend au moins une seconde couche et **en ce que** la couche du revêtement la plus proche de la première pièce est une couche intermédiaire (9) servant de moyens d'accrochage (7) entre ledit revêtement (3) et la première pièce (5).

13. Procédé de réalisation selon les revendications 11 ou 12, **caractérisé en ce que** la couche intermédiaire (9) possède une affinité chimique avec le premier matériau et la couche du revêtement (3) la plus proche de la première pièce (5), ou avec le premier matériau (5) et la couche de revêtement sur laquelle ladite couche intermédiaire (9) est déposée, permettant d'accélérer le procédé d'inter-diffusion des atomes améliorant ainsi l'accrochage dudit revêtement à ladite première pièce.

14. Procédé de réalisation selon les revendications 11 ou 12, **caractérisé en ce que** la couche intermédiaire (9) est fusible permettant le brasage de la couche du revêtement la plus proche de la première pièce (5) ou la couche de revêtement (3) sur laquelle ladite couche intermédiaire est déposée, avec la première pièce lors de l'étape d) de mise en forme ou après l'étape d) de mise en forme mais avant l'étape e) de séparation.

15. Procédé de réalisation selon l'une des revendications précédentes, **caractérisé en ce qu'**il comprend en outre, après l'étape e) de séparation de la première pièce de la seconde pièce, l'étape f) consistant à cristalliser la première pièce (5) de sorte à accélérer l'inter-diffusion entre les atomes du revêtement et ceux du premier matériau.

16. Procédé de réalisation selon l'une des revendications précédentes, caractérisé en ce la première pièce (5) comprend en outre au moins un autre revêtement, lesdits revêtements étant déposés sur des surfaces distinctes de la première pièce.

17. Procédé de réalisation selon l'une des revendications précédentes, **caractérisé en ce que** l'étape b) utilise le procédé de dépôt CVD ou PVD ou électro-déposition pour le dépôt dudit revêtement.

18. Procédé de réalisation selon l'une des revendications précédentes, **caractérisé en ce que** ledit premier matériau est totalement amorphe.

19. Procédé de réalisation selon l'une des revendications précédentes, **caractérisé en ce que** ledit premier matériau est un alliage métallique.
